# EUROPEAN PATENT APPLICATION

(11) **EP 2 560 196 A1**
(43) Date of publication of application: **20.02.2013**
(21) Application number: 11177562.3
(22) Date of filing: 15.08.2011
(51) Int. Cl.: H01L 21/288, H01L 21/3063, H01L 21/768, C25D 5/02, C25F 3/14

(54) **Method and system for forming a metallic structure**

(71) Applicant: Nederlandse Organisatie voor Toegepast -Natuurwetenschappelijk Onderzoek TNO, 2628 VK Delft (NL)
(72) Inventor: Bullema, Jan Eite, 5706 KT Helmond (NL); Roozeboom, Freddy, 2628 VK Delft (NL); Van der Donck, Jacques Cor Johan, 2628 VK Delft (NL); Bressers, Petrus Marinus Martinus Cornelus, 5283 TP Boxtel (NL)
(74) Representative: Jansen, Cornelis Marinus

(57) **Abstract**

Method of forming a metallic structure (2) in a micro-machined recess that is provided in a surface of a semiconductor substrate (8). The method comprises positioning a protrusion (10) of an apparatus for depositing the metallic structure at least partly inside the recess, thus partly occupying the recess with the protrusion and defining in the recess a gap (14) along the protrusion. The method comprises driving a deposition fluid (20) through the gap in the recess along the protrusion. The method comprises growing in the gap the metallic structure by depositing metal ions contained by the deposition fluid. The method comprises moving the protrusion and the substrate relative to each other so that the protrusion, while being positioned in the recess, moves relative to the recess in a direction out of the recess, thus giving way for the growing of the metallic structure, and forming the metallic structure in the recess.

## Description

The invention relates to a method of forming a metallic structure in a micro-machined recess that is provided in a surface of a semiconductor substrate. The invention further relates to a system comprising a semiconductor substrate having a surface provided with a plurality of micromachined recesses, and an apparatus for forming a plurality of metallic structures individually in the plurality of micromachined recesses. The invention also relates to a semiconductor substrate having a surface provided with a recess wherein a metallic structure is provided according to the method and/or by means of the apparatus. The invention further relates to a semiconductor product, such as a chip or a photovoltaic cell, provided with the semiconductor substrate.

Manufacturing of semiconductor substrates having a surface provided with metal-filled recesses has been applied extensively in the semiconductor industry. Through-silicon vias are examples of such metal-filled recesses. Usually, a width of a via is much smaller than a depth of a via. Hence, an aspect ratio of the recess defined as a depth of the recess divided by a width of the recess, is usually much larger than one. Having a small width of the vias and other recesses may be advantageous, because it usually enables further diminishing a size of the surface of the substrate.

A problem with filling of recesses, in particular recesses having a relatively large aspect ratio, is that a time required for filling the recesses may be relatively large. When the aspect ratio is relatively large, during filling of recesses voids may occur inside the metallic structure relatively easily, as metal adhering to opposing parts of an inner side wall of the recess may connect relatively easily and may thus enclose a void. For vias, such voids may disturb electrical flow inside the via and may deteriorate a strength of the via. Substantially preventing such voids may require a relatively slow filling process.

US 2009/0035940 discloses an example of manufacturing through-silicon vias manufactured by filling a recess with copper, deposited from an electrolytic fluid by means of electroplating. The electrolytic fluid of US 2009/0035940 contains copper ions, components that enhance the rate of copper deposition, and components that suppress the rate of copper deposition. It is stated in US 2009/0035940 that, by choosing appropriate components, a deposition speed of metal on the inner side walls is suppressed. However, by means of the electrolytic fluid used in US 2009/0035940, typical deposition speeds can still be lower than desirable. Furthermore, electrolytic fluids like those used in US 2009/0035940 may be costly and a freedom to design the composition of the fluid may be limited.

Accordingly, there is a need to at least partly meet a problem of the prior art, e.g. to increase a deposition speed for depositing a metallic structure, such as a via, in a micro-machined recess that is provided in a surface of a semiconductor substrate.

Thereto the invention provides a method of forming a metallic structure in a micro-machined recess that is provided in a surface of a semiconductor substrate, thus preferably forming a via in the semiconductor substrate, the method comprising the steps of: - positioning a protrusion of an apparatus for depositing the metallic structure at least partly inside the recess, thus partly occupying the recess with the protrusion and defining, by the protrusion positioned in the recess, a gap between a recess wall and the protrusion; - driving a deposition fluid through the gap in the recess along the protrusion, said deposition fluid containing metal ions; - growing in the gap the metallic structure by depositing the metal ions contained by the deposition fluid, preferably by means of an electroplating deposition process or an electroless deposition process; - moving, during growing of the metallic structure and/or after growing a part of the metallic structure, the protrusion and the substrate relative to each other so that the protrusion, while being positioned in the recess, moves relative to the recess in a direction out of the recess, thus giving way for the growing of the metallic structure, and forming the metallic structure in the recess.

By driving the deposition fluid through the gap, ions of deposition fluid are actively brought relatively close to the inner surface of the recess. Without wanting to be bound by any theory, the inventor realised that, by defining, by the protrusion positioned in the recess, a gap between a recess wall and the protrusion, a relatively large diffusion length of metal ions may be prevented. Thus, it may be explained that a deposition speed of depositing the metallic structure may be relatively large.

Additionally, such deposition speed may show a relatively large independence from composition of the deposition fluid.

Additionally, as the protrusion may be positioned at least partly inside the recess, it may be enabled that growing of the metallic structure from a bottom of the recess can be favoured over growing of the metallic structure from the inner side walls of the recess. Thus, a probability of voids to occur in the metallic structure may be decreased.

In an embodiment, driving the deposition fluid comprises dispensing the deposition fluid in the recess through a deposition nozzle included in the apparatus in or adjacent to the protrusion. Preferably, the deposition nozzle is included in the protrusion, preferably at a tip of the protrusion, and faces the recess and/or is positioned in the recess during the driving of the deposition fluid. Including the nozzle at the tip of the protrusion may effectively enable filling of the recess from a bottom surface of the recess. Using a protrusion that includes the deposition nozzle at its tip may decrease a possibility, or may even substantially prevent, that voids occur in the metal structure. Such a protrusion may substantially prevent that metal that has grown on opposing parts of the inner surface of the recess may connect and thus enclose a void.

Additionally or alternatively to said embodiment, driving the deposition fluid may comprise forcing the deposition fluid to flow over the surface of the semiconductor substrate, and/or may comprise repeatedly moving the protrusion through the recess so that the deposition fluid flows through the recess. Combination of various ways of driving the fluid, in particular combining dispensing the deposition fluid in the recess through the deposition nozzle with moving the protrusion through the recess, thereby defining, by the protrusion positioned in the recess, a gap between a recess wall and the protrusion may further decrease the thickness of a diffusion layer of the deposition fluid, with low diffusion lengths for the metal ions in the diffusion layer and increased mass transport of metal ions comprised in the deposition fluid.

According to an aspect of the invention, the method comprises the manufacturing of the micro-machined recess by means of a micromachining method. Said micromachining method may comprise positioning the protrusion and the substrate relative to each other so that the protrusion faces the recess and/or is positioned inside the recess during manufacturing of the recess. Thus, a self-aligned process may be obtained, wherein, after forming the recess, the protrusion faces or is positioned in the recess. (Such self-alignement may be especially valuable when using a head with a plurality of protrusions.) Thus, an alignment step in between forming of the recess and filling of the recess with the metallic structure, may be omitted. Said manufacturing may be carried out before filling the recess with the metallic structure.

According to an aspect of the invention, the micromachining method comprises electro-chemical machining, comprising the steps of: - providing an etch fluid for etching the recess in the semiconductor substrate; - defining a position on which the etch fluid is provided by means of the protrusion; and - applying an electric field over at least a part of the semiconductor substrate that is to be etched away. Electro-chemical machining may be applied on relatively large area's, e.g. on a plurality of wafers, each forming a semiconductor substrate, simultaneously. Thus electro-chemical machining may be attractive with respect to throughput and cost. Preferably, the method comprises dispensing the etch fluid through an etch nozzle that is included in the apparatus in or adjacent to the protrusion, thus providing the etch fluid and defining a position on which the etch fluid is provided by means of the protrusion. Optionally, the etch fluid comprises an isotropic etch fluid, preferably comprising at least one of hydrofluidic acid, acetatic acid, and nitric acid, or comprises an anisotropic etch fluid, preferably comprising an alkaline etch fluid, e.g. comprising potassium hydroxide, natrium hydroxide, and/or tetramethylammonium hydroxide.

Preferably, the deposition nozzle and etch nozzle are formed by one and the same nozzle. Preferably, the method comprises switching, after dispensing the etch fluid through the nozzle, towards dispensing the deposition fluid through the nozzle. In an embodiment, an electric field polarity may also be switched between the protrusion and the semiconductor substrate, for instance, substantially at the same time, to change from etching to deposition. Thus, a step of replacing the etch nozzle by the deposition nozzle, and/or and/or aligning the deposition nozzle in a step separate from positioning the etch fluid nozzle, may be prevented. In some embodiments, also during deposition and/or the etching the polarity may be switched repeatedly or intermittently to optimize a etching or deposition behaviour and/or to prevent gas forming. Typically, in electric discharge machining, the etch fluid is formed by a dielectric fluid.

In an embodiment, the method comprises providing in or adjacent to the recess, during etching, a metal element, for example, a metal piece comprising a material such as gold, silver or copper, for depositing a seed layer on the inner surface of the recess. Alternatively, the metal element may be formed by metal ions that are comprised in the etch fluid.

According to a further aspect of the invention, the micromachining method comprises electrical-discharge machining, comprising the steps of: - providing an etch fluid for providing a discharge therein during electrical-discharge machining; and - defining a position on which the dielectric fluid is provided by means of the protrusion. Preferably, the method comprises dispensing the dielectric fluid through a etch fluid nozzle that is included in the apparatus in or adjacent to the protrusion, thus providing the etch fluid and defining a position on which the dielectric fluid is provided by means of the protrusion. Preferably, the method comprises dispensing the dielectric fluid through a etch fluid nozzle that is included in the apparatus in or adjacent to the protrusion, thus providing the etch fluid and defining a position on which the dielectric fluid is provided by means of the protrusion.

Preferably, the deposition nozzle and the etch fluid nozzle are formed by one and the same nozzle, the method comprising switching, after dispensing the etch fluid through the nozzle, towards dispensing the deposition fluid through the nozzle. Thus, a step of replacing the etch fluid nozzle by the deposition nozzle, and/or aligning the deposition nozzle in a step separate from positioning the etch fluid nozzle, may be prevented.

According to a still further aspect, the method comprises applying a passivation layer that forms at least part of the inner wall of the recess after at least part of the recess has been formed by means of the micromachining. Preferably, micromachining the recess is carried out in a plurality of micromachining steps. Preferably, applying the passivation layer is carried out in a plurality of passivating steps. Preferably, said micromachining steps and passivating steps are carried out alternatedly. Thus, a variation of exposure time to the etch fluid between various parts of the semiconductor substrate in the recess, can be decreased. This is because, after applying the passivation layer, exposure of the semiconductor substrate can be substantially stopped or can at least be decreased. Preferably, applying the passivation layer comprises the steps of: - providing a passivation fluid for applying the passivation layer on the at least part of the recess; and - defining a position on which the passivation fluid is provided by means of the protrusion. Preferably, the method comprises dispensing the passivation fluid through a passivation-fluid nozzle that is included in the apparatus in or adjacent to the protrusion. Thus, the passivation fluid may be provided and a position may be defined on which the passivation fluid is provided by means of the protrusion. Applying the passivation layer optionally comprises positioning the protrusion and the substrate relative to each other so that the protrusion faces the recess and/or is positioned inside the recess during applying the passivation layer. Preferably, the etch nozzle and the passivation-fluid nozzle are formed by one and the same nozzle. Preferably, the method comprises switching, after dispensing the etch fluid through the etch nozzle, towards dispensing the passivation fluid through the passivation-fluid nozzle. Thus, a step of replacing the passivation-fluid nozzle by the deposition nozzle or vice versa, and/or a step of positioning and aligning the deposition nozzle separate from positioning and aligning the passivation-fluid nozzle, may be prevented.

The invention also provides a system comprising a semiconductor substrate having a surface provided with a plurality of micromachined recesses, and an apparatus for forming a plurality of metallic structures individually in the plurality of micromachined recesses, preferably for forming a plurality of vias in the semiconductor substrate, the apparatus comprising: - a deposition head provided with a plurality of protrusions that are positioned in a pattern that is similar to a pattern of the recesses so that the protrusions of the apparatus can be positioned individually at least partly into the recesses; - a substrate holder for holding the substrate; - positioning means arranged for positioning the substrate holder and the head relative to each other so that, in use, the protrusions of the apparatus are positioned at least partly into the recesses, the system thus being arranged for partly occupying the recesses with the protrusions and defining a plurality of gaps in the recesses along the protrusions; - deposition-fluid driving means for driving a deposition fluid through the gaps between the protrusions and the inner surface of the recesses, said deposition fluid containing metal ions; and - deposition means arranged for growing in the gaps the metallic structures by depositing the metal ions contained by the deposition fluid, the deposition means preferably being arranged for carrying out an electroplating deposition process and/or an electroless deposition process, for growing in the gaps the metallic structures by depositing the metal ions contained by the deposition fluid; wherein the positioning means are further arranged for moving, during growing of the metallic structure and/or after growing a part of the metallic structure, the protrusions and the substrate relative to each other so that the protrusions, while being positioned in the recess, move relative to the recess in a direction out of the recess, thus, in use, giving way for the growing of the metallic structure, and forming the metallic structure in the recess. The invention also provides the apparatus of the system. The invention further provides the substrate of the system.

By positioning the protrusion in or at least very close to the recess, a gap between the protrusion and recess is defined, and the deposition fluid is driven through the gap, so that ions of deposition fluid may be actively brought relatively close to the inner surface of the recess. Without wanting to be bound by any theory, the inventor realised that, by defining the gap, a relatively large diffusion length of metal ions may be prevented. Thus, it may be explained that a deposition speed of depositing the metallic structure may be relatively large. Thus, the system, and in particular the apparatus of the system, may enable increasing a deposition speed for depositing a metallic structures, such as a vias, in micro-machined recesses that are provided in a surface of a semiconductor substrate.

Additionally, such a system and apparatus enable carrying out micromachining and forming of the metallic structures in one and the same apparatus space. Hence, handling and/or repositioning the substrate may be substantially prevented or may be less frequent.

In an embodiment, the deposition-fluid driving means comprise deposition nozzles for dispensing the deposition fluid in the recesses, said deposition nozzles being included in the apparatus in or adjacent to the protrusions, preferably at a tip of the protrusions. The deposition nozzles may be arranged in the head for, in use, facing the recesses and/or being positioned in the recesses during the driving of the deposition fluid. Preferably, one deposition nozzle per protrusion is included.

In an embodiment, the deposition-fluid driving means comprise an outlet that, in use, extends along at least part of the surface of the semiconductor substrate for forcing the deposition fluid to flow over the surface of the semiconductor substrate.

In an embodiment, the deposition-fluid driving means comprise actuation means for repeatedly moving the protrusions and/or the substrate holder, so that the protrusions move through the recess and the deposition fluid flows through the recess.

In an embodiment, the apparatus comprises etch-fluid driving means for driving an etch fluid through the gaps between the protrusions and the inner surface of the recesses. Said etch-fluid driving means may include etch nozzles for dispensing the etch fluid in the recesses, said etch nozzles being included in the apparatus in or adjacent to the protrusions, preferably at a tip of the protrusions, for providing the etch fluid in contact with the semiconductor substrate and defining a position on which the etch fluid in use is provided by means of the protrusions. Preferably, a deposition nozzle and an etch nozzle of individual protrusions are formed by one and the same nozzle, easing alignment challenges and providing a more compact apparatus may be obtained. Preferably, the apparatus comprises a first switch for switching between dispensing the etch fluid through the nozzle and dispensing the deposition fluid through the nozzle.

In an embodiment, the apparatus further comprises etch fluid driving means for driving an etch fluid through the gaps between the protrusions and the inner surface of the recesses. The etch fluid driving means may include etch fluid nozzles for dispensing the dielectric fluid in the recesses. Said etch fluid nozzles may be included in the apparatus in or adjacent to the protrusions, preferably at a tip of the protrusions, for providing the dielectric fluid in contact with the semiconductor substrate and defining a position on which the dielectric fluid in use is provided by means of the protrusions. Preferably, one etch fluid nozzle per protrusion is included.

Preferably, a deposition nozzle and a etch fluid nozzle of individual protrusions are formed by one and the same nozzle easing alignment challenges and providing a more compact apparatus. Preferably, the apparatus comprising a second switch for switching between dispensing the etch fluid through the one and the same nozzle and dispensing the deposition fluid through the one and the same nozzle. If applicable simultaneously switching the polarity of the machining potential

In an embodiment, the apparatus comprises passivation-fluid driving means for driving a passivation fluid through the gaps between the protrusions and the inner surface of the recesses. The passivation-fluid driving means may include passivation-fluid nozzles for dispensing the passivation fluid in the recesses. Said passivation-fluid nozzles may be included in the apparatus in or adjacent to the protrusions, preferably at a tip of the protrusions, for providing the passivation fluid in contact with the semiconductor substrate and defining a position on which the fluid in use is provided by means of the protrusions. Preferably, one passivation-fluid nozzle per protrusion is included.

Preferably, an etch nozzle and a passivation-fluid nozzle of individual protrusions are formed by one and the same nozzle easing alignment challenges and providing a more compact apparatus. The apparatus may comprise a third fluidic switch for switching between dispensing the passivation fluid through the nozzle and dispensing the etch fluid through the nozzle.

In an embodiment, the semiconductor substrate has a surface provided with a recess wherein a metallic structure is provided, e.g. that is filled with the metallic structure, according to a method according to the invention and/or by means of an apparatus according to the invention. Preferably, the semiconductor substrate has a surface provided with a plurality of recesses wherein a plurality of metallic structures are provided individually, e.g. that are individually filled with the plurality of metallic structures, according to a method according to the invention and/or by means of an apparatus according to the invention.

The invention further provides a semiconductor product, such as a chip or a photovoltaic cell, provided with a semiconductor substrate according to the invention.

Embodiments of the invention will now be described with reference to the accompanying drawings, in which corresponding reference symbols indicate corresponding parts, and in which:
Figure 1A show a protrusion partly positioned in a recess, wherein a metallic structure has grown over a first height;
Figure 1B shows the a protrusion partly positioned in a recess and moved in a direction out of the recess, wherein a metallic structure has grown over a second height being larger than the first height;
Figure 1C shows a metallic structure having a third height being equal to a thickness of a substrate, while the protrusion has moved completely out of the recess;
Figure 2A shows the semiconductor substrate 8, the protrusion 10, and an example of the etch nozzle;
Figures 2B shows a protrusion during an etching process, wherein the recess has been formed up to a first depth;
Figures 2C shows a protrusion during an etching process, wherein the recess has been formed up to a second depth being larger than the first depth;
Figure 2D shows a protrusion being positioned inside a recess having the second depth during applying a passivation layer;
Figure 2E shows a protrusion during an etching process, wherein the recess extends through the substrate;
Figure 2F shows a protrusion being positioned inside a recess having the third depth during applying a passivation layer;
Figure 3A shows a system comprising a semiconductor substrate and an apparatus, in an embodiment according to the invention;
Figure 3B illustrates an apparatus provided with dicing means; and
Figure 3C illustrates an apparatus provided with electrical probing and/or optical inspection means.

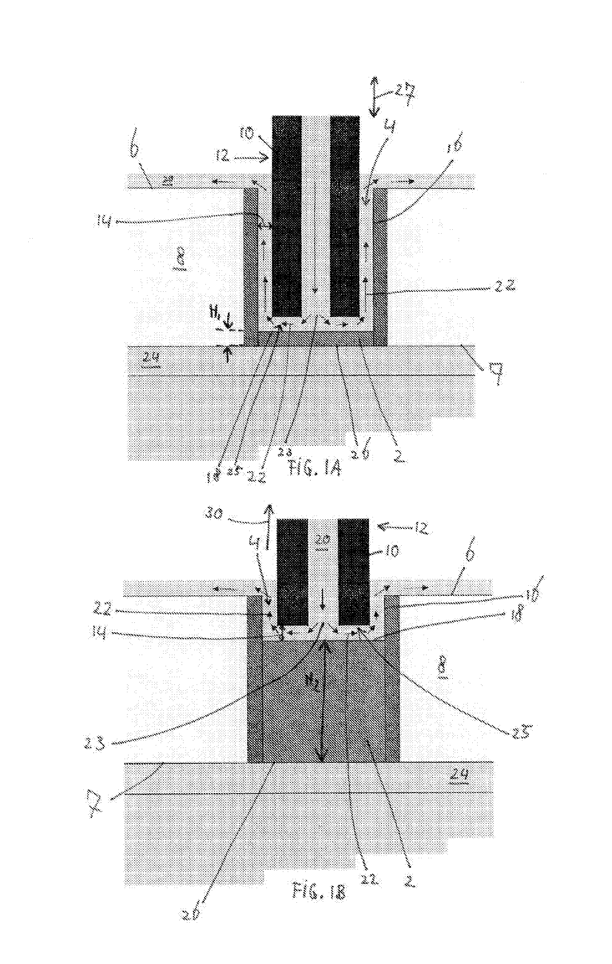

A first embodiment of a method according to the invention of forming a metallic structure 2 in a micro-machined recess 4 (the first method), is illustrated by means of figures 1A-1C. The recess 4 is provided in a surface of a semiconductor substrate 8, preferable in a first main surface 6 of the semiconductor substrate 8.

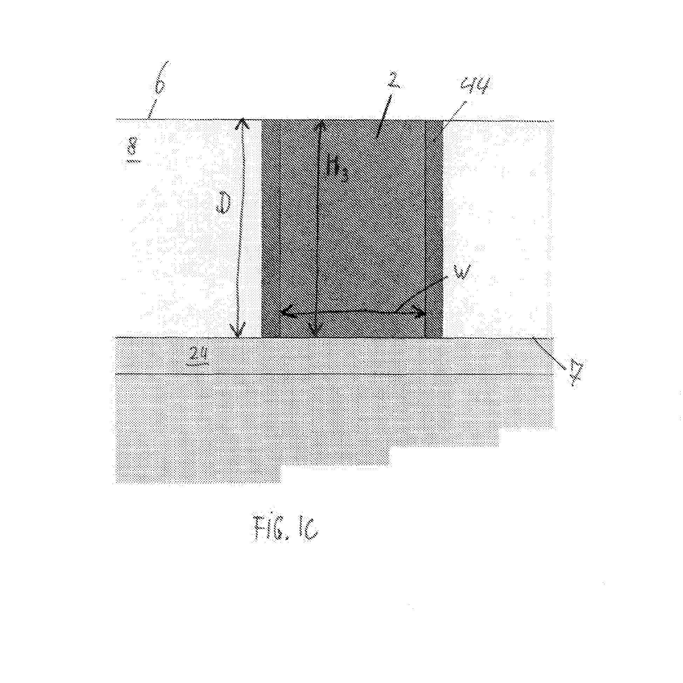

By carrying out the first method or another embodiment of a method according to the invention, a via 2 in the semiconductor substrate may be formed. Such a via may be a through-silicon via (TSV), as shown in figure 1C. The TSV typically comprises an electrical connection passing completely through the substrate 8, in a direction transverse to the first main surface 6. The TSV may have the conductive structure 2 positioned within a passivation layer 44.

A typical width W, e.g. a diameter, of a TSV may be larger than 0.5 micrometer and/or smaller than 350 micrometer. A typically value of a height of a TSV, being equal to a thickness D of the substrate, divided by a width W of the TSV, may be in a range from 1 to 50, but can also be larger than 50, e.g. can be approximately equal to 400. TSVs can e.g. be used in 3-dimensional (3D) integrated circuits (ICs). A single integrated circuit may be built by stacking silicon substrates and/or dies and interconnecting them vertically by means of one ore more TSVs, so that they behave as a single device. By using TSV technology, critical electrical paths through a 3D integrated circuit may be shortened, leading to faster operation. Also, TSVs can e.g. be used in 3D packages that contains two or more (vertically) stacked chips. Such stacked chips may occupy a reduced amount of space. Usually, stacked chips are wired together along their edges. Such edge wiring may increase a length and width of the package, and may increase a thickness by requiring an extra interposer layer between the chips. In some 3D packages, TSVs may replace edge wiring by creating vertical connections through a body of the chips (i.e. through the substrate 8). When using TSVs, the resulting package may be substantially free of added length or width or thickness caused by the external wiring and/or interposer layer.

The first method may comprise the step of positioning a protrusion 10 at least partly inside the recess 4. Said protrusion 10 may be part of an apparatus 12 for depositing the metallic structure 2. By positioning the protrusion 10 at least partly into the recess 4, the recess 4 is occupied partly with the protrusion 10. Thus, a gap 14 is defined in the recess 4 along the protrusion 10. Said gap 14 may be defined between on the one hand the protrusion 10, and on the other hand an inner surface 16 of the recess 4 and/or a free surface 18 of the metallic structure 2 that is positioned inside the recess 4 and extends in a direction transverse to the inner surface 16. At the start of growing, the gap 14 may be defined between the protrusion 10 and a bottom surface 26 of the recess 4.

The first method may further comprise driving a deposition fluid 20 through the gap 14 along the protrusion 10 in the recess 4. As a result of said driving, the deposition fluid 20 flows through the gap 14.

In a variation of the first method, illustrated by figures 1A and 1B, driving the deposition fluid may comprise dispensing the deposition fluid 20 in the recess 4 through a deposition nozzle 23 included in the apparatus 12. The deposition nozzle 23 may be positioned in or adjacent to the protrusion 10. The deposition nozzle 23 may be included in the protrusion 10, in particular at a tip 25 of the protrusion 10 (as shown in figures 1A and 1B). The deposition nozzle 23 may thus be positioned in the recess 4 during the driving of the deposition fluid 20. Alternatively, e.g. when the deposition nozzle is not included in the protrusion 10 at the tip 25 of the protrusion, the deposition nozzle may face the recess during the driving of the deposition fluid 20. Flow of the deposition fluid that can be reached in this variation, e.g. flow through the gap 14, is indicated by arrows 22. Preferably, in use the deposition fluid 20 flows away from the tip 25 of the protrusion 10.

In a further variation of the first method, driving the deposition fluid 20 comprises forcing the deposition fluid 20 to flow over the surface 6 of the semiconductor substrate 8. Such forcing of the deposition fluid may comprise supplying the deposition fluid on the substrate, e.g. from a slotted supply that extends along the surface 6. Such forcing may further comprise holding the substrate surface 6 in a tilted orientation so that gravity forces force the deposition fluid to flow over the substrate surface 6.

In a still further variation of the first method, driving the deposition fluid 20 comprises repeatedly moving the protrusion 10 through the recess 4 so that the deposition fluid 20 flows through the recess 4. E.g., the protrusion may be vibrated and/or moved through the recess 4 as a plunger. The protrusion may be repeatedly moved e.g. in a longitudinal direction 27 of the protrusion 10 and/or transverse to said longitudinal direction 27.

The deposition fluid 20 may contain metal ions, e.g. copper, aluminium, and/or silver ions. Thus, a further step of the first method may be enabled. Said further step comprises growing in the gap 14 the metallic structure 2 by depositing the metal ions contained by the deposition fluid by means of an electroplating deposition process or an electroless deposition process. By means of such processes, metal ions can be deposited, e.g. on a part of the metallic structure that has already be grown or an another metallic surface. Thus, the metallic structure, e.g. comprising copper, aluminium, and/or silver, can be grown.

In order to carry out electroplating, more in general, an electric field may be applied in the gap 14. Thereto a potential difference may be applied between the protrusion 10, in particular a conductive material comprised by the protrusion 10, and a conductive element 24. Preferably, as a result of said electric field, the metal ions of the deposition fluid 20 are attracted away from the protrusion 10 towards the conductive element 24. The conductive element 24 may be spaced apart from the protrusion 10 so that the metallic structure 2 grows in a space between the conductive element 24 and the protrusion 10. The conductive element 24 may be formed by a conductive, preferably adhesive, layer. The conductive element, e.g. said conductive layer, may form the bottom surface 26 of the recess 4. The conductive element, e.g. said conductive layer, may be applied to a second main surface 7 of the semiconductor substrate that is opposite to the first main surface 6. Examples of electroplating processes are known as such to the skilled person, so that a further description is deemed superfluous.

The conductive element 24 may comprise copper, aluminum, silver, and/or gold. The conductive element 24, in particular the adhesive conductive layer, may comprise e.g. gold coated polymer balls, silver flakes, nickel particles and/or copper particles Alternatively or additionally, the conductive element 24 may comprise bismuth, e.g. a bismuth alloy. The conductive element 24 may be deposited on the second main surface 7 of the substrate 8 and may be bonded thereto.

More in general, an embodiment of the invention may comprise controlling a size of the gap 14, in particular a size of the gap between the bottom surface 26 of the gap 14 and the tip 25 of the protrusion 10. Preferably, the gap between a distal part of the protrusion and a bottom wall, or, as the case may be, a deposition nozzle opening 23 in the protrusion 10 and a recess wall 26, is chosen as small as possible without undue impeding of fluid delivery. Preferably, the size of the gap 14 is controlled to be below 1 micrometer, for example about 0.1 micrometer, or below 10 micrometer. Preferably, the size of the gap 14 is controlled to be at most 20 micrometer, at most 50 micrometer, or at most 100 micrometer depending on fluid characteristics, the recess and protrusion dimensions.

Such gaps may enable that transport of metal ions is larger than in conventional plating. Without wanting to be bound by any theory, the recess 4 may be employed as a micro-electrochemical cell, leading to low diffusion lengths for the metal ions of the deposition fluid. Due to defining, by the protrusion positioned in the recess, a gap between a recess wall and the protrusion the boundary/diffusion layer wherein mass transport of metal ions takes place is controlled so that relatively large diffusion rates may be realised. E.g. a diffusion coefficient of copper ions in the deposition fluid in the gap 14 may in an example be in the order of 10⁻⁶ cm²/s, i.e. in a range from 10⁻⁷ cm²/s to 10⁻⁵ cm²/s. The diffusion length substantially determines a deposition rate of the ions, hence a growth speed of the metallic structure. In a gap with a size of about 10 micrometer, the diffusion speed may be as large as about 100 micrometer / hour. In a conventional electrochemical cell the diffusion speed is about 10 micrometer / hour.

In order to carry out electroless deposition, a metallic seed layer may be provided on which the metal ions of the deposition fluid 20 can be deposited. Said seed layer may e.g. be formed by the adhesive layer 24 when forming the bottom surface 26 of the recess 4. Alternatively, said seed layer may be formed by the growing metallic structure 2 itself. In particular, the seed layer may be formed by the free surface 18 of the metallic structure 2 that is positioned inside the recess 4 and extends in a direction transverse to the inner surface 16. Examples of electroless deposition processes are known as such to the skilled person, so that a further description is deemed superfluous.

In a further step, the first method may comprise moving the protrusion 10 and the substrate 8 relative to each other. As a result of said moving, the protrusion 10, while being positioned in the recess 4, may move relative to the recess 4 in a direction 30 out of the recess 4. As a result, the protrusion 10 gives way for the growing of the metallic structure 2. Thus, the metallic structure 2 in the recess 4 can be formed. Such is illustrated, by way of example, in figures 1A-1C. Figure 1A shows the protrusion 10 partly positioned in the recess 4, wherein the metallic structure has grown over a first height H₁. Figure 1B shows the protrusion 10 partly positioned in the recess and moved in the direction 30 out of the recess, while the metallic structure has grown over a second height H₂ being larger than the first height H₁. Finally, figure 1C shows the metallic structure having a third height H₃ being equal to a thickness D of the substrate 8, while the protrusion 10 has moved completely out of the recess 4. Thus, the metallic structure 2 may be grown from the bottom surface 26 of the recess 4 upwards. Moving the protrusion 10 and the substrate 8 relative to each other may be carried out, during growing of the metallic structure. Then, said moving and said growing may occur simultaneously. Alternatively or additionally, said moving may be carried out after growing a part of the metallic structure 2. Hence, moving and growing may be carried out intermittently and/or alternatedly. Hence, said moving and said growing may be alternated when carrying out said further step.

The deposition nozzle opening 23 may be arranged sideways of distal end portion of protrusion 10 instead of facing the bottom wall of the recess. In addition, the protrusion 10 may virtually contact, for example, in a controlled vibrating contact or controlled retraction during growing the bottom wall of the recess, while incidentally allowing a fluid flow gap between a wall of the protrusion and a recess wall.

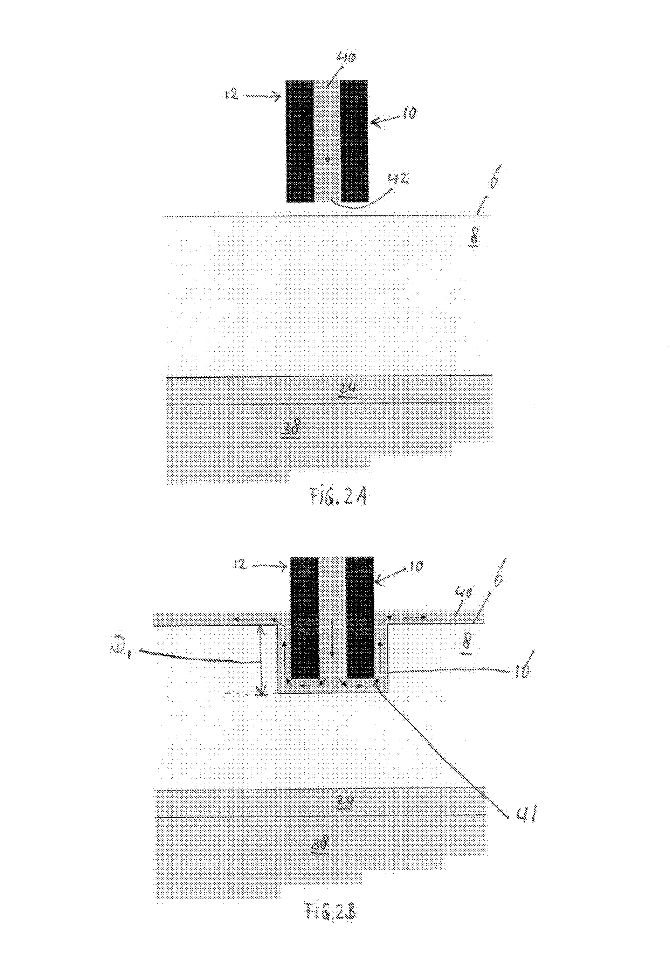

Figures 2A-2F illustrate a second embodiment of a method according to the invention (the second method). The second method comprises the manufacturing of the micro-machined recess by means of a micromachining method. Additionally, the second method may comprise one or more steps of the first method. The micromachining method of the second method may, in an embodiment, comprise positioning the protrusion 10 and the substrate 8 relative to each other so that the protrusion 10 is positioned inside the recess during manufacturing of the recess 4. Such an embodiment is illustrated by means of figures 2B-2F, which show the protrusion 10 being positioned inside the recess 4. Alternatively, or additionally, an embodiment of the micromachining method may comprise positioning the protrusion 10 and the substrate 8 relative to each other so that the protrusion 10 faces the recess 4. More in general, micromachining is carried out by using the protrusion 10, positioned inside the recess 4 and/or facing the recess 4.

In a variation of the second method, the micromachining method comprises electro-chemical machining. Electro-chemical machining may have an advantage is that it may be based on a relatively rapid process. Additionally, it may be applied to relatively large areas. Electrochemical machining may comprise the step of providing an etch fluid 40 for etching the recess 4 in the semiconductor substrate. In an embodiment, the electrochemical machining employed in the second method may further comprise defining a position on which the etch fluid is provided by means of the protrusion 10. Thereto, for example, an etch nozzle 42 may be provided in the apparatus 12 in or adjacent to the protrusion 10. The second method may comprising dispensing the etch fluid through the etch nozzle 42. Thus, the etch fluid 40 may be provided, and a position may be defined on which the etch fluid 40 is provided, by means of the protrusion 10. As a result of said dispensing, the etch fluid 40 will flow through the gap 14. Flow of the etch fluid is indicated by arrows 41. More in general, the first method may comprise driving, e.g. by said dispensing, the etch fluid 40 through the gap 14 along the protrusion 10 in the recess 4. The first main surface 6 of the substrate 8 may, during electro-chemical etching, be protected with a protective etch-resistant layer (e.g. a silicon nitride layer), although this is not necessary. Said protective layer may be patterned, having openings on positions where recesses 4 are to be formed. Hence, the etch-resistant layer may form an etch mask.

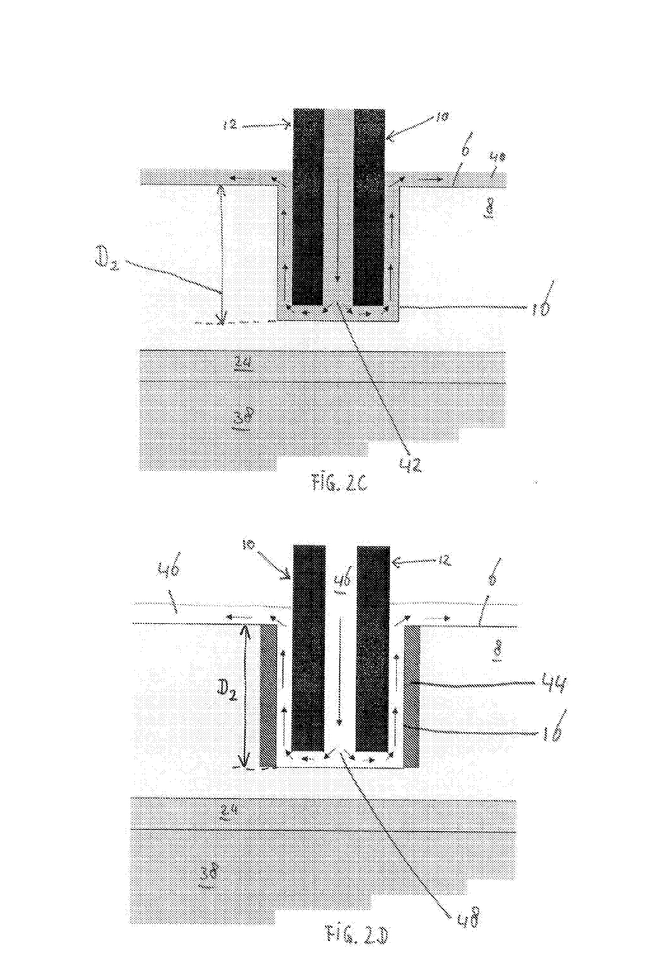

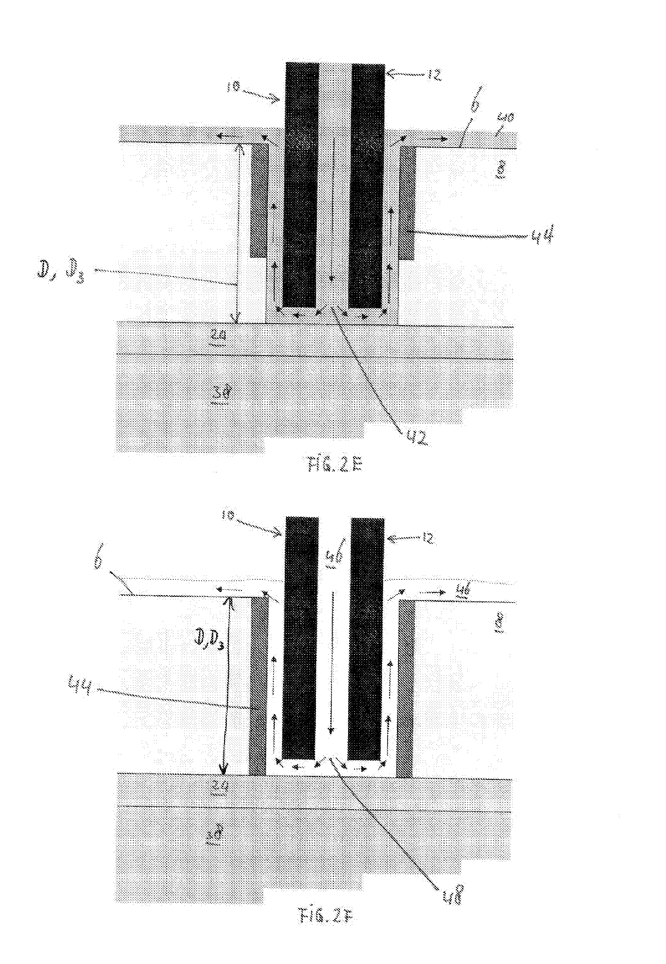

Figure 2A shows the semiconductor substrate 8, the protrusion 10, and an example of the etch nozzle 42. Figures 2B, 2C and 2E show the protrusion 10 during the etching process. In figure 2B, the recess has been formed up to a first depth D₁. In figure 2C, the recess has been formed up to a second depth D₂ that is larger than the first depth D₁. In figure 2E, the recess 4 has been formed up to a third depth D₃ that is larger than the second depth D₂. The depth D₃ may be equal to a thickness D of the substrate measured in a direction transverse to the surface 6 of the substrate 8. Hence, as illustrated in figure 2E, the recess may extend through the substrate 8. Although such extension of the recess may be appreciated when forming a via, the second method can also be used for forming a recess that does not extend through the substrate 8. The recess 4 may e.g. form, or be part of, a surface structure on the surface 6 of the substrate 8. It my thus, more in general, be clear that micromachining the recess may comprise positioning the protrusion 10 at an increasing depth in the recess during formation of the recess. Manufacturing the recess 4 may be stopped when a desired depth has been reached. During forming the recess, a depth (D₁, D₂, D₃) of the recess may be measured by measuring a displacement of the protrusion 10. Alternatively, or additionally, the depth may be inferred from a change in a potential difference between the protrusion 10 and the conductive element 24. As is apparent from figures 2B, 2C, and 2E, during etching the protrusion 10 may be positioned partly inside the recess as far as it has been formed. As can be seen in figure 2A, before etching the protrusion may face the first main surface 6 of the substrate 8. In an initial stage of etching, the protrusion may face the first main surface 6 or the recess 4 as far as it has been formed.

Advantageously, the deposition nozzle 23 and etch nozzle 42 may be formed by one and the same nozzle 23, 42. The second method may comprise switching, after dispensing the etch fluid 40 through the deposition nozzle 23 and/or the etch nozzle 42, towards dispensing the deposition fluid 20 through the deposition nozzle 23. A conventional fluid switch, e.g. comprising a valve, may be used for said switching. Various etch fluids 40 may be used when the semiconductor substrate comprises silicon or is made of silicon. The etch fluid 40 may be an isotropic etch fluid, e.g. comprising at least one of hydrofluidic acid, acetatic acid, and nitric acid. Alternatively, the etch fluid may be an anisotropic etch fluid, optionally comprising an alkaline etch fluid, e.g. comprising potassium hydroxide, natrium hydroxide, and/or tetramethylammonium hydroxide. As a generally applicable process step, after micromachining and before forming the metallic structure 2, a direction of the applied electric field may be reversed. Similarly, a polarity of the applied potential between the protrusion 10 and the conductive element 24 may be reversed.

Electro-chemical machining may comprise applying an, e.g. pulsed, electric field over at least a part of the semiconductor substrate 8 that is to be etched away. Thereto the protrusion 10 may comprise a conductive material, e.g. tungsten or molybdenum. Thus, the protrusion 10 may be used as an electrode for carrying out electro-chemical machining. The electrode may be made of a material like tungsten or molybdenum. The electrode can be hollow, e.g. needle-like. to allow for the application of the etch fluid or another fluid into the recess. The semiconductor substrate 8 may be mounted on a carrier wafer 38. The carrier wafer may be provided with the conductive element 24. The conductive element 24 may e.g. be formed by a metal filled conductive adhesive, or a metal layer that may comprise bismuth. Said electric field for electro-chemical machining may be applied by applying a potential difference between the conductive material of the protrusion 10 and the conductive element 24. Electrochemical etching may be stopped by taking away the potential difference between the protrusion 10 and the conductive element 24, e.g. by closing an electrical switch.

During electro-chemical machining, the protrusion 10, that may function as electrode, may be moved further down in the recess being formed. An electrolyte (e.g. etch fluid already used for etching) that flows out of the recess being formed, may be flushed with a washing liquid. Thus, the first main surface 6 may be protected. This may be especially valuable in case a protective layer is not used on the first main surface 6. Depending on the process settings (electrode potential, electrolyte chemistry, electrode vibration, pulses in the applied electric field), micromachining of the (e.g. silicon) substrate 8 may be performed. In water based electrolyte, hydrogen may be formed at the protrusion 10. Movement or vibration of the protrusion 10 may prevent formation of bubbles. Repeatedly moving the protrusion 10 through the recess 4 may also be applied for flushing of used etch fluid.

Example of electrochemical etching are known as such by the skilled person. Using electro-chemical machining ( photo induced electro chemical machining) to create vias in silicon is e.g. described in: Izou S., French P., 'A novel electrochemical etching technique for n-type silicon', Sensors and Actuators A9-98 (2002) 720-724. However, therein the use of a protrusion 10 as used e.g. in said variation of the second embodiment is not disclosed. Electrochemical machining of silicon is, separate from Izou & French, also described in: 'Electrochemical Micromachining of p-Type Silicon', P. Allongue, Fritz-Haber Institut der Max Planck Gesellschaft, J. Phys. Chem. B, 2004, 108 (38), pp 14434-14439. Therein, it is disclosed that electro-chemical micromachining of p-type Si substrates can be performed by using HF-based solutions as an etch fluid. Electric pulses with a duration in the nanoseconds range (e.g. in between 1 and 100 nanoseconds) may be applied between the substrate and the electrode. With sufficiently strong electrical pulses, the silicon potential locally reaches an electropolishing regime and microstructures may be machined. Pulse height, pulse duration, composition of the etch fluid, and/or silicon doping level may be varied to optimise electro-chemical machining. In highly doped p-Si, well-defined microstructures can be realized without application of a protective mask on a surface of the silicon substrate. In the case of low-doped silicon, electro-chemical machining may be possible for relatively short pulses (e.g. <3 nanoseconds).

In an embodiment, a method according to the invention may include providing in or adjacent to the recess, during etching, a metal element, e.g. copper. Such a metal element may e.g. be provided in the form of metal ions contained in the etch fluid. The inventors found, surprisingly, that providing a metal element enables the deposition of a seed layer on the inner surface of the recess during etching. Such a seed layer may e.g. be advantageously used for forming the metal structure 2, e.g. by means of an electroless deposition process. Thus, this embodiment may include providing in or adjacent to the recess, during etching, a metal element such as gold, silver or copper, for depositing a seed layer on the inner surface of the recess. In particular, the metal element may be formed by metal ions that are contained by the etch fluid.

In a further variation of the second method, the micromachining method comprises electrical-discharge machining. Electrical-discharge machining may comprise the step of providing an etch fluid for providing a discharge therein during electrical-discharge machining. In an embodiment, electrical discharge machining may further comprise defining a position on which the fluid is provided by means of the protrusion 10. Thereto, e.g., a etch fluid nozzle may be included in the apparatus in or adjacent to the protrusion 10. The second method may comprising dispensing the dielectric fluid through the etch fluid nozzle. Thus, the dielectric fluid may be provided and a position may be defined on which the dielectric fluid is provided by means of the protrusion 10. More in general, the second method may comprise driving the dielectric fluid through the gap 14 along the protrusion 10 in the recess 4. As a result of said driving, the dielectric fluid will flow through the gap 14. Advantageously, the deposition nozzle 23 and the etch fluid nozzle are formed by one and the same nozzle 23. The second method may comprise switching, after dispensing the dielectric fluid through the deposition nozzle and/or the dielectric fluid nozzle, towards dispensing the deposition fluid through the deposition nozzle. A conventional fluid switch, e.g. comprising a valve, may be used for said switching. Electrical-discharge machining is a micromachining method that is known as such to the skilled person, so that a further description is deemed superfluous.

In a still further variation of the second method, micromachining may comprise Deep Reactive Ion Etching (DRIE), laser drilling, powder blasting, and/or mechanical drilling.

After formation of the metallic structure, e.g. of the TSV, the substrate can be cleaned and inspected. Optionally, dies can be formed from the semiconductor substrate 8, optionally by means of electro-chemical machining, e.g. by means of using the protrusion 10.

The second method may, optionally, comprise applying a passivation layer 44 that forms at least part of the inner wall 16 of the recess 4. Said passivation may, more in general, comprise an electrical isolation layer to prevent, or decrease a probability for, electrical shunt between the metal structure 2 and the silicon substrate 8. Alternatively or additionally, the passivation layer may comprise a diffusion barrier layer to prevent diffusion of material of the metal structure 2 into the semiconductor substrate 8. The electrical isolation layer and the diffusion barrier layer may be combined into a single passivation layer 44. Thus, the passivation layer 44 may be arranged to form both said electrical isolation and said diffusion barrier. Various kind of material may be used for applying the passivation layer 44, for example tantalum, tantalum oxide, silicon nitride, silicon oxide, and/or polymer materials. Preferably, a plurality of passivation layers are applied to increase a reliability of prevention of electrical shunt and material degradation through diffusion.

The passivation layer 44 may be applied after at least part of the recess has been formed by means of the micromachining. Applying the passivation layer 44 may comprise positioning the protrusion and the substrate relative to each other so that the protrusion faces the recess and/or is positioned inside the recess during applying the passivation layer. Figures 2D and 2F show the protrusion 10 being positioned inside the recess during applying the passivation layer 44. Alternatively or additionally, the protrusion 10 may be positioned so that the protrusion faces the recess during application of the passivation layer 10.

Applying the passivation layer may comprise the step of providing a passivation fluid 46 for applying the passivation layer on the at least part of the recess. The passivation fluid may comprise an electrolyte that can be deposited to form the passivation layer, e.g. a barrier layer and/or an isolation layer. The passivation fluid may e.g. comprise tantalum-fluoride for forming a barrier layer. Alternatively the passivation fluid may comprise copper-nitrate, sodium-nitrate, or potassium-nitrate for formation of silicon oxide for forming an isolation layer. Figures 2D and 2F illustrate application of the passivation layer, by means of the fluid 46.

Applying the passivation layer 44 may further comprise defining a position on which the passivation fluid is provided by means of the protrusion. Thereto, a passivation-fluid nozzle 48 may be included in the apparatus in or adjacent to the protrusion 10. The second method may comprise dispensing the passivation fluid through the passivation-fluid nozzle 48. Thus, the passivation fluid may be provided and a position may be defined on which the passivation fluid is provided, by means of the protrusion. Advantageously, the etch nozzle and the passivation-fluid nozzle 48 are formed by one and the same nozzle 42, 48.

The passivation layer may be applied after at least part of the recess 4 has been formed by means of the micromachining. Preferably, applying the passivation layer 44 is in general alternated with carrying out micromachining to increase a depth of the recess 4. As a result of such alternation, it may be prevented that parts of the substrate along the inner surface 16 are much, e.g. 2, 5, or 10 times, longer exposed to the etch fluid than other parts of the substrate along the inner surface 16. For example, without a passivation layer 44, parts of the substrate 8 along the inner surface 16 located relatively close to the first main surface 6, would be exposed to the etch fluid much longer than other parts of the substrate 8 along the inner surface 16 located relatively far away from the first main surface 6.

Figure 2C shows micromachining, in this example etching, the recess 4. Figure 2D shows subsequent applying of the passivation layer. Figure 2E shows subsequent further micromachining, here etching, the recess 4. Figure 2F shows subsequent further applying of the passivation layer 44. Thus, figures 2C-2E illustrate alternately applying the passivation layer and micromachining the recess. It may thus be clear that, in general, micromachining the recess 4 may be carried out in a plurality of micromachining steps (e.g. shown in figures 2C and 2E), and wherein applying the passivation layer is carried out in a plurality of passivating steps (e.g. shown in figures 2D and 2F), said micromachining steps and passivating steps being carried out intermittently and/or alternatedly. Thus, at least one of the passivating steps may be applied in between micromachining steps.

The second method may comprising switching, after dispensing the etch fluid through the etch nozzle, towards dispensing the passivation fluid through the passivation-fluid nozzle. The second method may comprise switching, after dispensing the etch fluid 40 through the passivation nozzle 48 and/or the etch nozzle 42, towards dispensing the passivation fluid 46 through the passivation nozzle 48, and/or vice versa. A conventional (etch-resistant) fluid switch, e.g. comprising a valve, may be used for said switching. Thus, e.g. by repeatedly switching, the flow of the passivation fluid can be alternated with the flow of the etch fluid. The protrusion 10 may be moved in the recess to promote chemical reactions of the substrate 8 inside the recess 4 for forming the passivation layer.

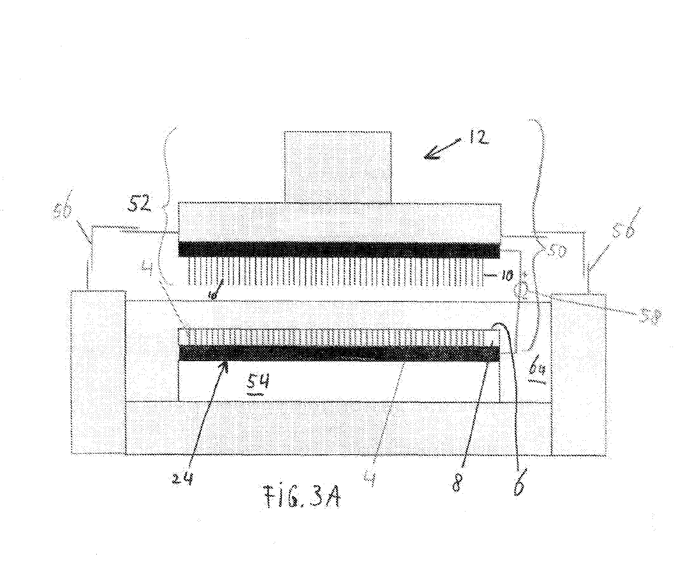

Figure 3A shows a system 50 comprising a semiconductor substrate 8 and an apparatus 12, in an embodiment according to the invention. The semiconductor substrate 8 has a surface, here the first main surface 6, provided with a plurality of micromachined recesses 4. The apparatus 12 is arranged for forming a plurality of metallic structures 2 individually in the plurality of micromachined recesses 4. Thus, one metallic structure per recess can be formed by means of the apparatus 12. Preferably, the apparatus is thus arranged for forming a plurality of vias 2 in the semiconductor substrate 8.

The apparatus 12 comprises a deposition head 52 provided with a plurality of protrusions 10. The protrusions 10 may be positioned in a first pattern. The recesses 4 may be positioned in a second pattern. The first pattern and the second pattern may be similar. As a result of such similarity, the protrusions 10 of the apparatus can be positioned individually at least partly into the recesses 4, in a single movement step between the head and the substrate. Thus, one protrusion 10 can be positioned in a recess 4. The similarity, hence mutually matching, of the first and second patterns may enable a relatively fast process of forming the metallic structures.

The apparatus 12 may further comprise a substrate holder 54 for holding the substrate. The substrate holder 54 may be provided with a vacuum chuck or other means for attaching the substrate to the substrate holder 54.

The apparatus 12 may further comprise positioning means arranged for positioning the substrate holder and the head relative to each other. Preferably, the apparatus is arranged for allowing relative movement in three orthogonal directions. The positioning means are schematically indicated in figure 3A by reference number 56. The positioning means 56 are arranged so that, as a result of the relative movement of the head and the holder relative to each other, the protrusions of the apparatus can be positioned at least partly into the recesses. The system may thus be arranged for partly occupying the recesses with the protrusions and defining a plurality of gaps 14 in the recesses 4 along the protrusions 10. Such gaps 14 are not shown in figure 3A but are visible in figures 1A-2F.

The apparatus 12 may further comprise deposition-fluid driving means for driving a deposition fluid through the gaps between the protrusions and the inner surface of the recesses. The deposition fluid may contain metal ions. Different variations of the fluid driving means are possible. For example, in a variation, the deposition-fluid driving means comprise deposition nozzles for dispensing the deposition fluid in the recesses 4. Said deposition nozzles may be included in the apparatus 12 in or adjacent to the protrusions 10, preferably at a tip 25 of the protrusions 10. The protrusions may be shaped as hollow needles. Figure 3A does not indicate the deposition nozzles. However, figures 1A-2F show an example of the deposition nozzles 23, arranged in the head for, in use, facing the recesses and/or being positioned in the recesses during the driving of the deposition fluid. In a further variation, the deposition-fluid driving means may comprise an outlet that, in use, extends along at least part of the surface of the semiconductor substrate for forcing the deposition fluid to flow over the surface of the semiconductor substrate. In a still further variation, the deposition-fluid driving means may comprise actuation means for repeatedly moving the protrusions and/or the substrate holder 54, so that the protrusions 10 move through the recesses 4 and the deposition fluid 20 flows through the recesses 4. The protrusions 10 may be solid, e.g. without a deposition nozzle or another nozzle. Such solid protrusions may especially benefit from the deposition fluid driving means in the further variation and the still further variation thereof.

The apparatus 12 may further comprise deposition means arranged for carrying out an electroplating deposition process and/or an electroless deposition process. The apparatus 12 may thus be arranged for growing in the gaps 14 the metallic structures 2 by depositing the metal ions contained by the deposition fluid by means of an electroplating deposition process or an electroless deposition process. For carrying out electroplating, the apparatus 12 may comprise an electrical source 58. The electrical source may be electrically connected to a conductive element 24 comprised by the apparatus. The electrical source 58 may further be electrically connected to a conductive material comprised by the protrusions 10. The substrate 8 may be positioned in between the head 52 provided with the protrusions, and the conductive element 24. Thus, by means of the electrical source 58, an electric field may be applied in the gaps 14 for carrying out the electroplating process. Further optional aspects of the conductive material of the protrusions 10 and of the conductive element 24 are described with reference to figures 1A-2F.

The positioning means 56 are further arranged for moving, during growing of the metallic structures 2 and/or after growing parts of the metallic structures, the protrusions 10 and the substrate 8 relative to each other. Preferably, such relative movement may enable that the protrusions 10, while being positioned in the recesses 4, can be moved relative to the recesses 4 in the direction 30 out of the recesses 4. Thus, way can be giving for the growing of the metallic structures 2. Thus, the metallic structures in the recesses 4 can be formed.

In a second embodiment, the apparatus may further comprise etch-fluid driving means for driving an etch fluid through the gaps 14 in the recesses 4 along the protrusions 10. Said etch-fluid driving means may include etch nozzles 42 for dispensing the etch fluid in the recesses 4. Said etch nozzles 42 may be included in the apparatus in or adjacent to the protrusions 10, preferably at a tip of the protrusions (see figures 2A-2F). Thus, the etch fluid can be provided in contact with the semiconductor substrate 8 and a position can be defined on which the etch fluid in use is provided, by means of the protrusions 10. A deposition nozzle 23 and an etch nozzle 42 of individual protrusions may be formed by one and the same nozzle. The apparatus may comprise a switch for switching between dispensing the etch fluid through the one and the same nozzle and dispensing the deposition fluid through the one and the same nozzle.

Alternative to the etch fluid-driving means, the apparatus may comprise etch fluid driving means. Said etch fluid driving means may be arranged for driving an etch fluid through the gaps 14 along the protrusions 10 in the recesses 4. Said etch fluid driving means may include etch fluid nozzles for dispensing the dielectric fluid in the recesses. Said etch fluid nozzles may be included in the apparatus in or adjacent to the protrusions 10, preferably at the tip 25 of the protrusions 10. Thus, the dielectric fluid can be provided in contact with the semiconductor substrate 8 and a position can be defined on which the dielectric fluid in use is provided, by means of the protrusions 10. A deposition nozzle and a etch fluid nozzle of individual protrusions 10 may be formed by one and the same nozzle. The apparatus may comprise a switch for switching between dispensing the dielectric fluid through the one and the same nozzle and dispensing the deposition fluid through the one and the same nozzle.

In an embodiment, the apparatus may comprises passivation-fluid driving means for driving a passivation fluid through the gaps 14 in the recesses 4 around the protrusions 10. The passivation-fluid driving means may include passivation-fluid nozzles 48 for dispensing the passivation fluid in the recesses 4. Said passivation-fluid nozzles may be included in the apparatus 12 in or adjacent to the protrusions 10, preferably at the tip 25 of the protrusions. Thus, the passivation fluid can be provided in contact with the semiconductor substrate 8 and a position can be defined on which the dielectric fluid in use is provided, by means of the protrusions 10. Figures 2D and 2F show an example of the passivation-fluid nozzles 48. Preferably, an etch nozzle and a passivation-fluid nozzle of individual protrusions are formed by one and the same nozzle. The apparatus comprising a switch for switching between dispensing the passivation fluid through the one and the same nozzle and dispensing the etch fluid through the one and the same nozzle.

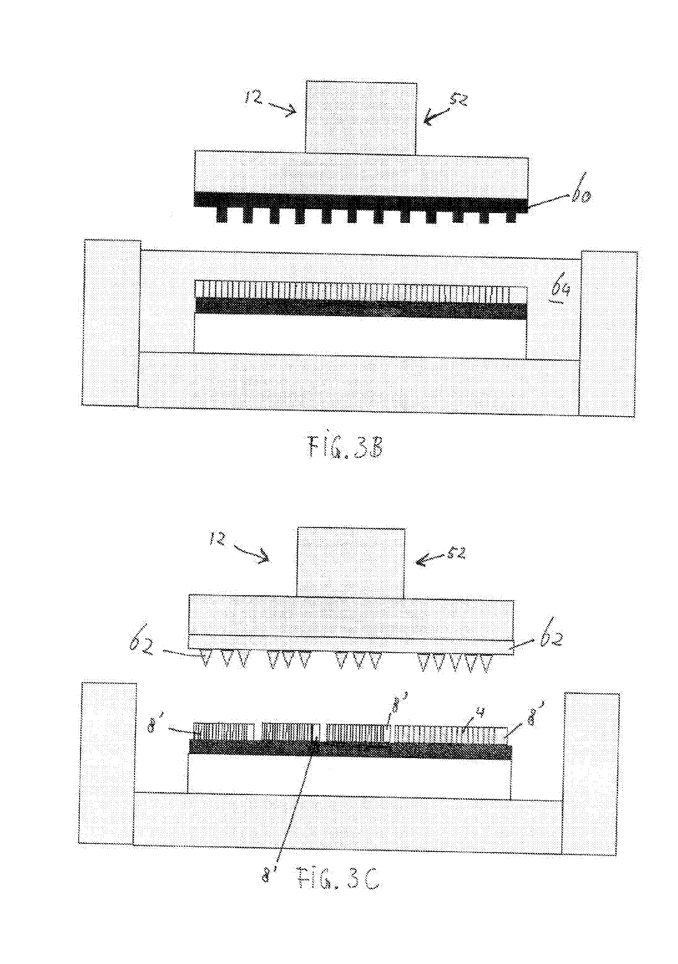

In a third embodiment, the apparatus may be arranged for formation of conductive metal patterns on the first and/or second main surface, in electrical contact with one or more of the recesses 4. Preferably, the apparatus 12 is arranged for dicing of the semiconductor substrate 8. Thereto the apparatus, in particular the head 52, may be provided with dicing means 60. Figure 3B illustrates the apparatus 12 provided with the dicing means 60. Preferably, the apparatus 12 is arranged for probing and/or visual inspection of the semiconductor substrate 8. Thereto the apparatus, in particular the head 52, may be provided with electrical probing and/or optical inspection means 62. Figure 3C illustrates the apparatus 12 provided with the electrical probing and/or optical inspection means 62. Figure 3C also shows dies 8' obtained after dicing the semiconductor substrate 8.

It may be appreciated that, by means of the apparatus in one or more different embodiments, a plurality of process step can be carried out. E.g., the apparatus in the second embodiment may be arranged for both micromachining and forming of the metallic structures 2. The apparatus in the third embodiment may, additionally, be arranged for dicing, probing, and/or visual inspection. Thus, a number of handling steps of the substrate and repeated positioning steps of the substrate may be prevented. Such may be appreciated as the substrate 8 may be relatively fragile and may be relatively susceptible to contamination. Furthermore, a speed may be increased.

By means of an apparatus according to the invention, optionally using a method according to the invention, a semiconductor substrate of a system according to the invention may be provided with the metallic structures. Thus, a semiconductor substrate having a plurality of recesses that are individually filled with a plurality of metallic structures may be provided. Such a semiconductor substrate may be used in a semiconductor product, e.g. in a chip or a photovoltaic cell, or a micro-electro-mechanical system (MEMS). E.g., TSVs may be used for creating electrical contacts, such as back contacts, emitter contact, or emitter wrap through contacts. Thus, electrical resistance of such contacts may be reduced. Usually, such contact may be made with a silver frit paste. Optionally, the invention can be used for creating metalized structures and textures in silicon. Examples of such structure are embedded capacitors, e.g. used in electronic systems, and light trapping structures, e.g. used in photovoltaic cells. Texturing of a solar cell at a front side (sunny side) and/or a back side (dark side) may reduce the reflection losses as well as assist in capturing photons.

The first and/or second method may comprise thinning of the semiconductor substrate 8. As a result, a thickness of the semiconductor substrate may be decreased. Such thinning may be carried out before creating the recess 4 and filling the recess 4 with the metallic structure 2. Alternatively, thinning may be carried out after manufacturing the recess 4 and before forming the metallic structure 2 in the recess 4. In particular, thinning the substrate is carried out after a blind recess (i.e. a recess that does not extend through the substrate) has been formed. Preferably, after thinning, the recess does extend through the semiconductor substrate 8. Thinning can be carried out e.g. by mounting the substrate 8 upon a carrier followed by grinding the substrate 8. Such grinding is performed typically in subsequent steps from coarse grinding towards finer grinding. Optionally, after grinding, a chemical etch step or a plasma etch step is applied. In this way, microscopic irregularities may be removed. Alternatively or additionally to grinding, thinning may comprise chemical thinning. Using chemical thinning for creation of TSVs is surprising.

It is further noted that, in general, the deposition-fluid driving means, the etch-fluid driving means, the etch fluid driving means, and/or the passivation-fluid driving means may optionally include a pump for pumping a fluid to a nozzle. It may further be appreciated that the first and second method may be carried out by using a plurality of protrusions 10, e.g. by using a system and/or apparatus according to the invention. Further, preferably, the semiconductor substrate 8 may be at least partly, or completely, immersed during processing, e.g. during forming the recess(es) 4 and/or during the micromachining of the recess(es) and/or during the dicing, in an immersion fluid (indicated with reference number 64). Such may reduce a probability of contamination of the substrate. It may further be appreciated that process steps of the first and second method may be performed at a relative low temperature, e.g. a temperature smaller than 80 degrees Celsius. Furthermore, after a metallic structure, e.g. a via, has been formed, on the metallic structure a bump may be formed, which protrudes from the first or second main surface, by continuing electroplating or electroless deposition after the recess has been filled.

It may thus be clear that the invention, according to an aspect thereof, may relate to a method were a complete process flow for the creation of through silicon vias (TSVs) can be combined in one apparatus and/or system; may, according to a further aspect thereof, relate to a method were Electro-Chemical-Machining and metal filling are performed by means of one tool, based upon the use of an conductive element (24) as carrier for the silicon wafer, e.g the in situ creation of a micro electrochemical cell; may, according to a still further aspect thereof, relate to use of a conductive element (24) to a side of the substrate were the silicon substrate is bonded to a carrier; may, according to a yet further aspect thereof, relate to use of an deposition head provided with hollow electrode pins, forming protrusions, forming a pattern of deposition nozzles, wherein a material of the pins is preferably tungsten or molybdenum, and wherein channels in the hollow pins are provided for, in use, to supply fluids in the recesses, wherein, preferably, side walls of the electrode pins are coated with a non conductive material, e.g. a thin film coating comprising siliconcarbide (SiC); and/or may, according to another aspect thereof, relate to use of a deposition head provided with solid (i.e. non-hollow) electrode protrusions forming a pattern of electrodes, wherein flow of fluids in the recesses is performed by a by a plunger action of the electrodes. For example, Silicon thinning, TSV creation, cleaning , TSV metal filling, cleaning, probing and dicing may be combined in one system.

The invention is not limited to any embodiment herein described. For example, the deposition means may be arranged for carrying out an electroplating deposition process and/or an electroless deposition process and/or another deposition process. Thus, the apparatus may be arranged for growing in the gaps the metallic structures by depositing the metal ions contained by the deposition fluid by means of an electroplating deposition process and/or an electroless deposition process and/or another process. The use of expressions like: "preferably", "in particular", "especially", "typically" etc. is not intended to limit the invention. The indefinite article "a" or "an" does not exclude a plurality. Features which are not specifically or explicitly described or claimed may be additionally comprised in the structure according to the present invention without deviating from its scope.

## Claims

1. Method of forming a metallic structure in a micro-machined recess that is provided in a surface of a semiconductor substrate, the method comprising the steps of:
- positioning a protrusion of an apparatus for depositing the metallic structure opposite and/or at least partly inside the recess thereby defining, by the protrusion positioned opposite the recess, a gap between a recess wall and the protrusion;
- driving a deposition fluid through the gap in the recess along the protrusion, said deposition fluid containing metal ions; and
- growing in the recess the metallic structure by depositing the metal ions contained by the deposition fluid.

2. Method according to claim 1, further comprising moving, during growing of the metallic structure and/or after growing a part of the metallic structure, the protrusion and the substrate relative to each other so that the protrusion moves, from a position partly occupying the recess, relative to the recess in a direction out of the recess, thus giving way for the growing of the metallic structure, and forming the metallic structure in the recess.

3. Method according to claim 1, wherein driving the deposition fluid comprises dispensing the deposition fluid in the recess through a deposition nozzle included in the apparatus in or adjacent to the protrusion, preferably at a tip of the protrusion, and faces the recess and/or is positioned in the recess during the driving of the deposition fluid.

4. Method according to claim 1, further comprising applying an electric field between the protrusion and a bottom wall of the recess wherein the protrusion is kept at a positive potential relative to the bottom wall.

5. Method according to claim 1, comprising the manufacturing of the micro-machined recess by means of a micromachining method that comprises positioning the protrusion and the substrate relative to each other so that the protrusion faces the recess and/or is positioned inside the recess during manufacturing of the recess.

6. Method according to claim 5, wherein the micromachining method comprises electro-chemical machining, comprising the steps of:
- providing an etch fluid for etching the recess in the semiconductor substrate;
- defining a position on which the etch fluid is provided by means of the protrusion; and
- applying an electric field between the protrusion the semiconductor substrate that is to be etched away.

7. Method according to claim 6, wherein the protrusion is kept at a negative potential relative to the semiconductor substrate.

8. Method according to claim 6, comprising dispensing the etch fluid through an etch nozzle that is included in the apparatus in or adjacent to the protrusion, thus providing the etch fluid and defining a position on which the etch fluid is provided by means of the protrusion.

9. Method according to claims 3 and 6, wherein the deposition nozzle and etch nozzle are formed by one and the same nozzle, the method comprising switching, after dispensing the etch fluid through the nozzle, towards dispensing the deposition fluid through the nozzle, and/or switching an electric field polarity between the protrusion and the semiconductor substrate.

10. Method according to claim 1, including providing in or adjacent to the recess, during etching, a metal element, preferably comprising a material such as gold, silver or copper, for depositing a seed layer on an inner surface of the recess.

11. Method according to claims 1, comprising applying a passivation layer that forms at least part of an inner wall of the recess after at least part of the recess has been formed by means of the micromachining.

12. Method according to claim 11, wherein micromachining the recess is carried out in a plurality of micromachining steps, and wherein applying the passivation layer is carried out in a plurality of passivating steps, said micromachining steps and passivating steps being carried out alternatedly.

13. Method according to claim 11 or 12, wherein applying the passivation layer comprises the steps of:
- providing a passivation fluid for applying the passivation layer on the at least part of the recess; and
- defining a position on which the passivation fluid is provided by means of the protrusion.

14. Method according to claim 15, comprising dispensing the passivation fluid through a passivation-fluid nozzle that is included in the apparatus in or adjacent to the protrusion, thus providing the passivation fluid and defining a position on which the passivation fluid is provided by means of the protrusion.

15. Method according to claims 8 and 14, wherein the etch nozzle and the passivation-fluid nozzle are formed by one and the same nozzle, the method comprising switching, after dispensing the etch fluid through the etch nozzle, towards dispensing the passivation fluid through the passivation-fluid nozzle.

16. System comprising a semiconductor substrate having a surface provided with a plurality of micromachined recesses, and an apparatus for forming a plurality of metallic structures individually in the plurality of micromachined recesses, preferably for forming a plurality of vias in the semiconductor substrate, the apparatus comprising:
- a deposition head provided with a plurality of protrusions that are positioned in a pattern that is similar to a pattern of the recesses so that the protrusions of the apparatus can be positioned individually opposite and/or at least partly into the recesses;
- a substrate holder for holding the substrate;
- positioning means arranged for positioning the substrate holder and the head relative to each other so that, in use, the protrusions of the apparatus are positioned opposite and/or at least partly into the recesses, the system thus being arranged for partly occupying the recesses with the protrusions and thereby defining, by a protrusion positioned opposite the recess, a gap between a recess wall and the protrusion;
- deposition-fluid driving means for driving a deposition fluid through the gaps between the protrusions and the inner surface of the recesses, said deposition fluid containing metal ions; and
- deposition means arranged for growing in the gaps the metallic structures by depositing the metal ions contained by the deposition fluid;
wherein the positioning means are further arranged for moving, during growing of the metallic structure and/or after growing a part of the metallic structure, the protrusions and the substrate relative to each other so that the protrusions, while being positioned in the recess, move relative to the recess in a direction out of the recess, thus, in use, giving way for the growing of the metallic structure, and forming the metallic structure in the recess.

17. System according to claim 16, wherein the deposition-fluid driving means comprise deposition nozzles for dispensing the deposition fluid in the recesses, said deposition nozzles being included in the apparatus in or adjacent to the protrusions, preferably at a tip of the protrusions, the deposition nozzles being arranged in the head for, in use, facing the recesses and/or being positioned in the recesses during the driving of the deposition fluid.

18. System according to claim 16 or 17, wherein the apparatus further comprises etch-fluid driving means for driving an etch fluid through the gaps between the protrusions and the inner surface of the recesses, wherein the etch-fluid driving means include etch nozzles for dispensing the etch fluid in the recesses, said etch nozzles being included in the apparatus in or adjacent to the protrusions, preferably at a tip of the protrusions, for providing the etch fluid in contact with the semiconductor substrate and defining a position on which the etch fluid in use is provided by means of the protrusions, wherein a deposition nozzle and an etch nozzle of individual protrusions are formed by one and the same nozzle, the apparatus comprising a first switch for switching between dispensing the etch fluid through the nozzle and dispensing the deposition fluid through the nozzle.
